Europäisches Patentamt

European Patent Office

Office européen des brevets

(19)

(11) **EP 0 735 453 B1**

(12) # EUROPEAN PATENT SPECIFICATION

(45) Date of publication and mention
of the grant of the patent:
**02.12.1998 Bulletin 1998/49**

(51) Int Cl.⁶: **G05F 3/00**, H03K 17/22

(21) Application number: **96302064.9**

(22) Date of filing: **26.03.1996**

(54) **A delay circuit and method**

Verzögerungsschaltung und Verfahren

Circuit de retard et procédé

(84) Designated Contracting States:
**DE FR GB IT**

(30) Priority: **28.03.1995 US 411556**

(43) Date of publication of application:
**02.10.1996 Bulletin 1996/40**

(73) Proprietor: **STMicroelectronics, Inc.**
**Carrollton Texas 75006-5039 (US)**

(72) Inventors:
• **Phillips, William A.**
**Royal Oak, MI 48073 (US)**
• **Paparo, Mario**
**95037 S. Giovanni Della Punta (CA) (IT)**
• **Capocelli, Piero**
**20131 Milan (IT)**

(74) Representative: **Palmer, Roger et al**
**PAGE, WHITE & FARRER**
**54 Doughty Street**
**London WC1N 2LS (GB)**

(56) References cited:
**EP-A- 0 405 319**          **US-A- 5 317 219**
**US-A- 5 382 840**

EP 0 735 453 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

This invention relates to electronic circuits used to delay signals and more specifically to circuits used to delay the turn-on of a power transistor in a bridge configuration.

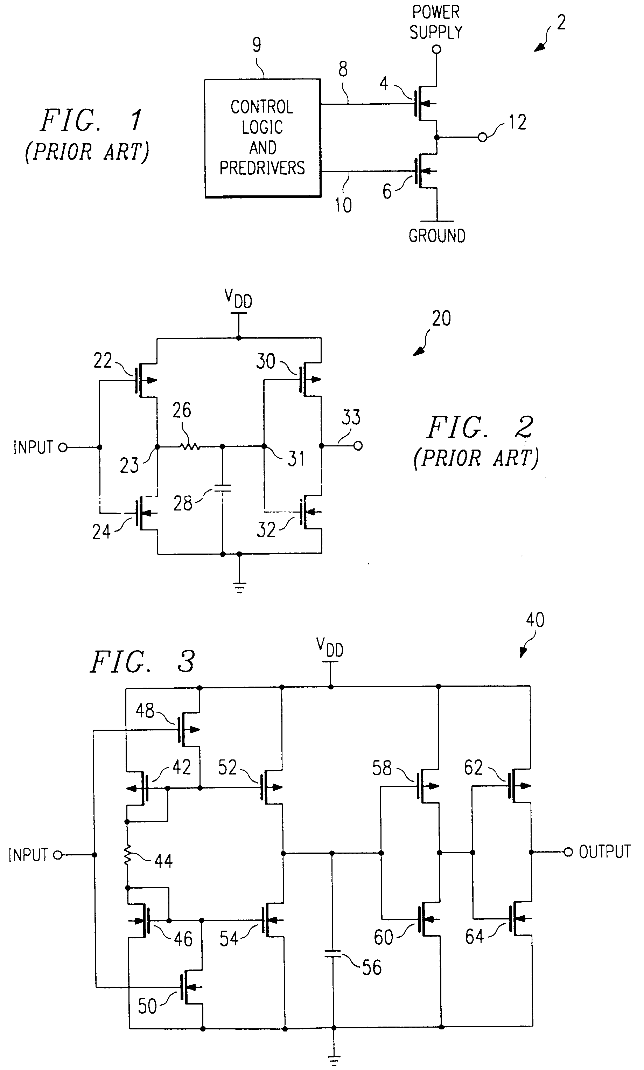

The problem addressed by this invention is encountered when power transistors are used to drive a prior art bridge configuration such as in Figure 1. The bridge configuration 2 can be used to power motors, drive solenoids, and the like. The bridge configuration 2 is characterized by the high side driver transistor 4 being connected in series to a low side driver transistor 6 across the voltage of a power supply. In this configuration, node 12 is driven to the power supply voltage when the high side transistor 4 is on and transistor 6 is off. Conversely, node 12 is sunk to ground when high side transistor 4 is off and lowside transistor 6 is on. If the high side and low side transistors are both turned off, then node 12 is at a high impedance state. However, if both high side 4 and low side 6 transistors are turned on, then the transistors are shorting the power supply voltage to ground which would draw an excessive amount of current and would damage one or both of the transistors. The bridge configuration is never used with both high side and low side drivers on at the same time because of the potentially disastrous results. Consequently, it is common to use a delay circuit as part of the control logic in the control block 9 to prevent the turn-on of one driver transistor until the other driver is turned off. In principle, one of the drivers is turned off while the other driver is turned on, but only after the delay circuit has delayed the turn-on by an amount of time which will guarantee that the other driver is in fact turned off.

Figure 2 illustrates a prior art delay circuit 20 used in the control block 9 of figure 1 for delaying the turn-on of the driver transistors 4 or 6. In delay circuit 20, p-channel transistor 22 and n-channel transistor 24 form a first inverter. Similarly, p-channel transistor 30 and n-channel transistor 32 form a second inverter. The gates of transistors 22 and 24 form the inputs of the first inverter and the drain of transistor 30 and the drain of transistor 32 form the output of the second inverter. In operation, as the input signal goes from a low voltage to a high voltage, transistor 22 turns off and transistor 24 turns on. As a result, the voltage at node 23 drops from near Vdd to near ground. Consequently, the charge on capacitor 28 is drained through resistor 26 and transistor 24. The rate of discharge is determined by the size of resistor 26 and capacitor 28 as is known in the art. When the voltage on node 31 reaches approximately 2.5 volts, transistor 32 turns off and transistor 30 turns on which raises the voltage at node 33. The time delay can be approximated by the equation:

$$T_{delay} = (R26)(C28)\ln(1 - Vdd/V_{threshold})$$

Therefore, the rising signal on the input of the delay circuit 20 is passed on to the output of the delay signal 33, but only after the delay created by the time constant of resistor 26 and capacitor 28. However, prior art delay circuit 20 is limited since it often requires relatively large capacitors and/or resistors to obtain long delays. The requirement of a large capacitor or resistor is undesirable since a large capacitor or resistor typically requires large amounts of silicon on an integrated circuit or requires an external connection for an external capacitor. Since the cost of a integrated circuit is directly proportional to the die size, it is desirable to reduce the size of a circuit whenever possible.

In addition, reference is made to US 5,382,840 which describes an analogue delay circuit configuration which includes a controlled current source for defining the current for the charging state of a capacitor. The charge/discharge current for the capacitor is controlled by providing a clocked control signal to the gate of a transistor which is in series with a current mirror configuration for providing the charging/discharging current. As with the prior art circuit of Figure 2, the input signal to be delayed is supplied directly to an inverter configuration, the transistors of which are connected between the capacitor and the current mirror paths.

US 5,317,219 describes a programmable compensated digital delay circuit which includes programmable voltage controlled current sources and capacitor networks to alter the delay.

Therefore, it is an object of the invention to provide relatively long delays without requiring a large capacitor or a large resistor.

It is further an object of this invention to provide a delay circuit which provides relatively long delays and without requiring large area on an integrated circuit.

It is further an object of this invention to provide a delay circuit which reduces the cost of a delay circuit by reducing the die area necessary to implement the circuit.

According to one aspect of the present invention there is provided a delay circuit for delaying an input signal comprising: a constant source having an input for receiving an input signal and having a constant current output for providing a constant current responsive to the input signal; a constant current drain having an input for receiving the input signal and having a constant drain output for draining a constant current responsive to the input signal; a capacitor having a first plate and a second plate, the first plate of the capacitor connected to the constant current output of the constant current drain, the second plate connected to a voltage reference; and an output stage having an input connected to the first plate of the capacitor and having an output for providing an output responsive to the voltage on the capacitor, characterised in that, the input of the constant current source comprises a first input terminal and the input of the constant current drain comprises a second input terminal, the first and second input terminals being connected to the input signal to be delayed; and the first plate of the capacitor is connected directly to the constant current output of the constant current source and to the constant drain output of the constant current drain.

According to another aspect of the present invention there is provided a delay circuit for delaying an input signal comprising: a plurality of current mirror current sources, with each current mirror current source having an enable input, having a current mirror ratio, having a first input terminal for receiving the input signal and having a constant current output for providing a constant current proportionately responsive to the input signal in dependence on the current mirror ratio; a plurality of current mirror current drains, with each current mirror current drain having an enable input, having a current mirror ratio, having a second input terminal for receiving the input signal, and having a constant drain output for draining a constant current proportionately responsive to the input signal in dependence on the current mirror ratio; a programmable delay control circuit having a plurality of enable signals, each signal connected to a current mirror current source and current mirror current drain such that the programmable delay control circuit selectively enables a pair of current mirror current source and drain; a capacitor having a first plate and a second plate, the first plate of the capacitor directly connected to the constant current outputs of the plurality of current mirror current sources and to the constant drain outputs of the plurality of current drains, the second plate connected to a voltage reference; and an output stage having an input connected to the first plate of the capacitor and having an output for providing an output responsive to the voltage on the capacitor.

Some embodiments of the invention will now be described by way of example and with reference to the accompanying drawings in which:

Fig. 1 is a schematic drawing of a prior art bridge configuration.

Fig. 2 is a schematic drawing of a prior art delay circuit.

Fig. 3 is a schematic drawing of an embodiment of a delay circuit.

Fig. 4 is a plan view of a layout of an embodiment of the delay circuit on an integrated circuit.

Referring now to Fig. 3, a delay circuit 40 constructed according to an embodiment of the invention will be described. The input of the delay circuit 40 is connected to the gate of P-channel transistor 48 and to the gate of a n-channel transistor 50. The source of transistor 48 is connected to a voltage source Vdd and the drain of transistor 48 is connected to the gate of p-channel transistor 52, to the gate and drain of p-channel transistor 42, and to the first end of resistor 44. The second end of resistor 44 is connected to the drain and gate of n-channel transistor 46, to the gate of n-channel transistor 54, and to the drain of n-channel transistor 50. The sources of transistors 46, 50, and 54 are connected to a voltage reference, ground. The source of transistor 52 is connected to Vdd. The drain of transistor 52 is connected to the drain of transistor 54, to the first plate of capacitor 56, to the gate of p-channel transistor 58, and to the gate of n-channel transistor 60. The second plate of capacitor 56 is connected to ground. The source of transistor 58 is connected to Vdd. The source of transistor 60 is connected to ground. The drain of transistor 58 and the drain of transistor 60 are connected to the gate of p-channel transistor 62 and to the gate of n-channel transistor 64. The source of transistor 62 is connected to Vdd. The source of transistor 64 is connected to ground. The drain of transistor 62 is connected to the drain of transistor 64, the connection thereof forms the output of the delay circuit 40. Although the construction of this circuit is described using MOSFET transistors, it is understood in the art that a similar circuit can be constructed using bipolar transistors, and the like.

In operation, an input signal is received at the gates of transistors 48 and 50. If the input signal is at a low voltage, transistor 48 turns on which allows for transistors 46 and 54 to conduct a constant current through transistor 54. The constant current through transistor 54 discharges capacitor 56. Conversely, capacitor 56 is charged when the input signal is at a high voltage since this high input voltage turns transistor 48 off and turns transistor 50 on. Therefore, transistors 46 and 54 are held off while transistors 42 and 52 are turned on. Thus, transistor 52 charges capacitor 56 with the constant current source formed by transistor 42, resistor 44, and transistor 52. The voltage on capacitor 56 buffered to the output by two inverters formed with transistors 58, 60, 62, and 64. In short, an input signal is received by transistors 48 and 50, delayed by the constant current sources or drains in combination with the capacitor, and then buffered by two inverters to the output of the delay circuit 40.

More specifically, transistors 42, 52 and 50 combine with resistor 44 to form a constant current source when the input to the delay circuit is at a high voltage. In this state, transistor 50 draws current through resistor 44 which turns on the current mirror formed by transistors 42 and 52. In the preferred embodiment, Vdd is about 5 volts and R44 is approximately 84 Kohms which defines the current through transistor 42 at about 40 microamps. Transistor 42 has an w/l (area) of 180/9 and transistor 52 has an w/l (area) of 9/9. Thus, the current through transistor 42 is approximately 20 times the current through transistor 52. Thus the current in transistor 52 is approximately 2 microamps. This constant current charges capacitor 56 when the input voltage is high. In general, the time delay can be approximately described as

time delay = (switch voltage/ $V_{r44}$)(C56)(R44)(current ratio)

where:

switch voltage = the switch voltage for the inverter
$V_{r44}$ = the voltage drop across R44

C56 = the capacitance of capacitor 56

R44 = the resistance of resistor 44

current ratio = the current ratio of the applicable current mirror.

In an embodiment, a 10 picofarad capacitor, 84 kilo-ohm resistor, and current ratio of 20 are used which yields a delay of approximately (2.5v/4v) (10pF) (84k) (20) = 10.5 microseconds. (Note that the voltage drop across resistor 44 is reduced from Vdd by the voltage drop across the transistors in the current path, which in this case totals to around 1 volts.)

Conversely, transistors 48, 46, and 54 combine with resistor 44 to form a constant current drain for discharging capacitor 56. When the input of delay circuit 40 is at a low voltage, transistor 50 is off and transistor 48 is on. This allows current to flow through transistor 48 and resistor 44, thus, turning on transistors 46 and 54. With an 84 kohm resistor and 5 volt Vdd, the current through transistor 46 is approximately equal to 40 microamps. Transistor 46 has 20 times the area as transistor 54 so that the current through transistor 54 is about 2 microamps. Therefore, capacitor 56 is discharged at the rate of 2 microamps which creates a delay of about 10.5 microseconds when the input of delay circuit is low.

Transistors 58 and 60 are configured to invert the voltage on the capacitor 56. When the voltage on the gates of transistors 58 and 60 are low, the voltage on output is low and vice versa. Transistors 62 and 64 are also configured as an inverter with the gates configured as the input and the drain of transistor 62 connected to the drain of transistor 64 to form the output of the inverter. The first and second inverter form the output stage of the delay circuit and buffer the voltage on the capacitor to the output of the delay circuit 40. It is understood that numerous circuits can be used for buffering voltages without departing from the spirit and scope of the invention.

The embodiment of the invention offers the advantage providing a delay which over 12 times longer than the delay created by a prior art circuit using the same resistor and capacitor value. Alternatively, this embodiment of the invention creates the equivalent delay, but uses a resistor and/or capacitor which is approximately 12 times smaller than is required by the prior art circuit to achieve the same time delay.

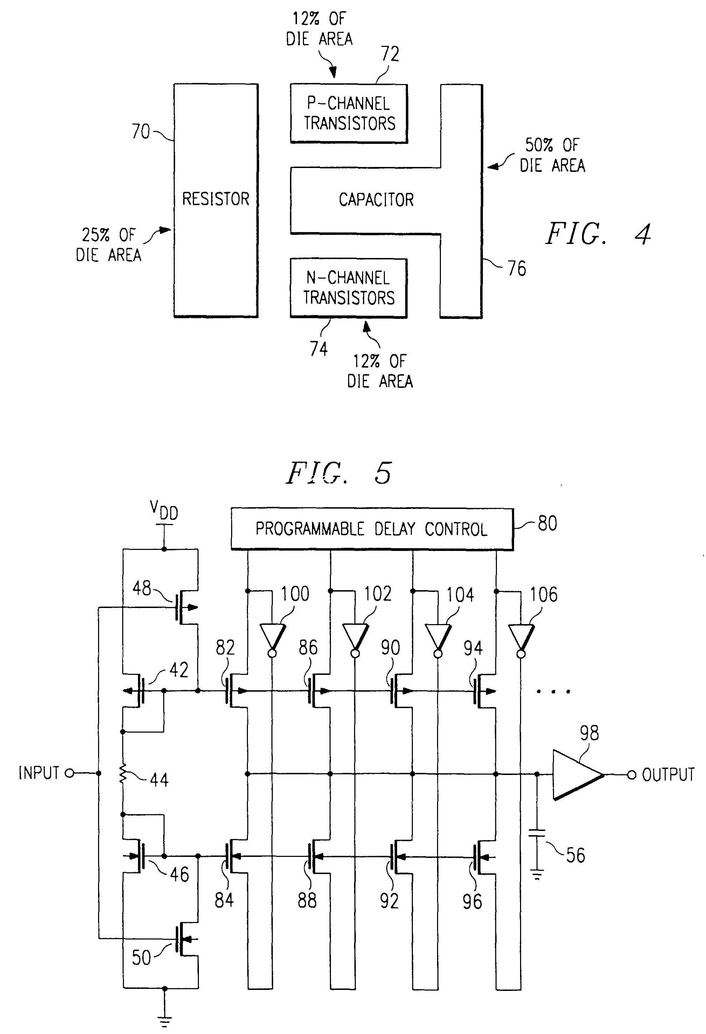

Fig. 4 shows the layout of the embodiment and illustrates that 75% of the area required to implement the embodiment is used by the resistor and capacitor. The layout includes resistor 70, p-channel transistors 72, n-channel transistors 74, and capacitor 76. It can be noted that the layout is for five p-channel transistors, five n-channel transistors, one 84 kilo-ohm resistor, and one 10 picofarad capacitor and yields a 10.5 microsecond delay. The prior art delay circuit in Fig. 2 requires 4 transistors instead of 6 but only provides a delay of around 823 nanoseconds or would require a capacitor or resistor which over 12 times larger to yield the same delay.

The layout in Fig. 4 shows that the extra transistors needed to implement the embodiment of the invention use much less area than the area needed to increase the resistance or capacitance by 12 times. Consequently this embodiment of the invention uses much less area than the prior art even though the invention requires 10 transistors (as compared to 4 transistors) because the transistors use much less area than capacitor or resistor which would be required. Therefore, the present invention provides relatively long delays without requiring large capacitors or resistors, without requiring a large area on an integrated circuit, and, thus, at a reduced cost relative to the prior art.

Figure 5 discloses another embodiment which adds programmability to the delay circuit. This embodiment is constructed by having the source of p-channel MOSFET transistor 42 connected to Vdd and having its drain connected to a first end of resistor 44. The second end of resistor 44 is connected to the drain of n-channel MOSFET transistor 46. P-channel MOSFET transistor 48 has a source connected to Vdd and a drain connected to the gate of transistor 42. The drain of n-channel MOSFET transistor 50 is connected to the gate of transistor 46. The sources of transistors 46 and 50 are connected to ground. The gate of transistor 48 is connected to the gate of transistor 50, the connection of which forms the input for the circuit. The gate of transistor 42 is connected to the gates of p-channel MOSFET transistors 82, 86, 90, and 94. The gate of transistor 46 is connected to the gates of n-channel MOSFET transistors 84, 88, 92 and 96. The sources of transistors 82, 86, 90, and 94 are connected to programmable delay control circuit 80. The drains of transistors 82, 84, 86, 88, 90, 92, 94, and 96 are connected to each other and the first plate of capacitor 56. The input of inverter 100 is connected to the source of transistor 82 and the output of inverter 100 is connected to the source of transistor 84. Similarly, the inputs of inverters 102, 104, and 106 are connected to the sources of transistors 86, 90, and 94, respectively. Likewise, the outputs of inverters 102, 104, and 106 are connected to the sources of transistors 88, 92, and 96, respectively. The second plate of capacitor 56 is connected to ground. The output of buffer amplifier 98 is the output of the circuit. The programmable delay control circuit 80 can be constructed using many common digital circuits including input/output device, RAM memory, ROM memory, EPROM, EEPROM, and the like.

In operation, this embodiment operates in an analogous manner to the previous embodiment, but with the added feature that capacitor 56 can now be charged or discharged by one or more pairs of current mirrors. Transistors 48 and 50 are the input transistors; transistors 42 and 46 are the bias transistors; transistors 82, 86, 90, and 94 are the constant-current source transistors; and transistors 84, 88, 92, and 96 are the constant-current drains, for this embodiment.

More specifically, an input signal enters the circuit through the gate of transistor 48 which turns on transistor 42. Since the gate of transistor 42 is connected to the gates of transistors 82, 86, 90, and 94, transistor 42 provides the bias voltage for transistors 82, 86, 90, and 94 such that the current flow in the respective transistor is proportional (mirrored) to the current through transistor 42. However, transistors 82, 86, 90, and 94 will only be turned on if programmable delay control circuit 80 has enabled one of those transistors by providing the source of the respective transistor with a positive voltage. Therefore, the rate of delay or the rate of charging capacitor 56 is controlled by the programmable delay control circuit 80 and the relative ratios of transistors 42 to transistors 82, 86, 90, and 94. Inversely, when the input signal goes low, transistor 50 turns on bias transistor 46 which thereby provides the bias voltage to turn on transistors 84, 88, 92, and 96 to remove the charge from capacitor 56. Again, transistors 84, 88, 92, and 96 will not drain any current from capacitor 56 unless the transistors have been enabled by programmable delay control circuit 80 providing a sufficiently low voltage to the respective transistors drain. In this disclosure, it is assumed that the enable signals from the programmable delay control signal are digital in nature with sufficient current drive to drive the MOSFET transistors.

It will be clear to persons skilled in the art that additional transistor pairs can be added to the circuit to increase the range of programmability. Four transistor pairs are disclosed for illustrative purposes and could easily be modified to less pairs or more pairs by persons skilled in the art. Additionally, persons skilled in the art can vary the ratio of the current mirrors to further increase the range of programmability. By adjusting the current mirror ratios and/or increasing the number of transistor pairs persons skilled in the art can easily design a programmable delay which meets a given design criteria for versatility as well as flexibility.

**Claims**

1. A delay circuit (40) for delaying an input signal comprising:

   a constant source (48,42,52,44) having an input for receiving an input signal (INPUT) and having a constant current output for providing a constant current responsive to the input signal;
   a constant current drain (46,54,50,44) having an input for receiving the input signal and having a constant drain output for draining a constant current responsive to the input signal;
   a capacitor (56) having a first plate and a second plate, the first plate of the capacitor connected to the constant current output of the constant current drain, the second plate connected to a voltage reference; and

   an output stage (58,60,62,64) having an input connected to the first plate of the capacitor (56) and having an output for providing an output responsive to the voltage on the capacitor, characterised in that,
   the input of the constant current source comprises a first input terminal and the input of the constant current drain comprises a second input terminal, the first and second input terminals being connected to the input signal to be delayed; and
   the first plate of the capacitor is connected directly to the constant current output of the constant current source and to the constant drain output of the constant current drain.

2. The delay circuit of claim 1, wherein the constant current source comprises a first current mirror.

3. The delay circuit of claim 1 wherein the constant current drain comprises a second current mirror.

4. The delay circuit of claim 2, wherein the first current mirror comprises a first transistor (42) having a control element connected to a conductive part of the first transistor and to a control element of a second transistor (52).

5. The delay circuit of claim 4, wherein the first and second transistors are MOSFETs.

6. The delay circuit of claim 5, wherein the MOSFETs are p-channel MOSFETs.

7. The delay circuit of claim 3, wherein the second current mirror comprises a third transistor (46) having a control element connected to a conductive part of the third transistor and to a control element of a fourth transistor (54).

8. The delay circuit of claim 7, wherein the third and fourth transistors are MOSFETs.

9. The delay circuit of claim 8, wherein the MOSFETs are n-channel MOSFETs.

10. A delay circuit for delaying an input signal comprising:

    a plurality of current mirror current sources (48,42,82,86,90,94), with each current mirror current source having an enable input, having a current mirror ratio, having a first input terminal for receiving the input signal and having a constant current output for providing a constant current proportionately responsive to the input signal in dependence on the current mirror ratio;

a plurality of current mirror current drains (46,50,84,88,92,96), with each current mirror current drain having an enable input, having a current mirror ratio, having a second input terminal for receiving the input signal, and having a constant drain output for draining a constant current proportionately responsive to the input signal in dependence on the current mirror ratio;

a programmable delay control circuit (80) having a plurality of enable signals, each signal connected to a current mirror current source and current mirror current drain such that the programmable delay control circuit selectively enables a pair of current mirror current source and drain;

a capacitor (56) having a first plate and a second plate, the first plate of the capacitor directly connected to the constant current outputs of the plurality of current mirror current sources and to the constant drain outputs of the plurality of current drains, the second plate connected to a voltage reference; and

an output stage (98) having an input connected to the first plate of the capacitor (56) and having an output for providing an output responsive to the voltage on the capacitor.

11. The delay circuit of claim 10 comprising:

a first input transistor (48) having a control element providing the first input terminal for receiving the input signal, and having a current path with a first end connected to a voltage source ($V_{DD}$) and a second end;

a second input transistor (50) having a control element providing the second input terminal for receiving the input signal, and having a current path with a first end and a second end connected to a voltage reference;

a first bias transistor (42) having a current path with a first end connected to the voltage source ($V_{DD}$), having a second end, and having a control element, wherein the second end is connected to the control element and to the second end of the current path of the first input transistor (48);

a resistor (44) having a first end connected to the second end of said first bias transistor and having a second end;

a second bias transistor (46) having a current path from the second end of said resistor to the voltage reference, and having a control element connected to the second end of said resistor and to the first end of the current path of said second input transistor (50);

a plurality of constant-current sources (82;86; 90;94), each constant current source of the plurality of constant-current sources having a current path between a corresponding enable output of said programmable delay control circuit (80) and the first plate of said capacitor (56), and having a bias input connected to the control element of said first bias transistor such that each current mirror current source comprises the first input transistor (48), the first bias transistor (42), one of said constant-current sources and the resistor (44);

a plurality of constant-current drains (84;88;92; 96), each constant current drain of the plurality of constant-current drains having a current path between a corresponding enable output of said programmable delay control circuit (80) and the first plate of said capacitor (56), and having a bias input connected to the control element of said second bias transistor such that each current mirror current drain comprises the second input transistor (50), the second bias transistor (46), one of said constant-current drains and the resistor (44).

12. The delay circuit of claim 10 or 11, wherein said programmable delay circuit (80) comprises a digital circuit.

13. The delay circuit of claim 12, wherein the digital circuit comprises a programmable memory circuit.

14. The delay circuit of claim 13, wherein the programmable memory circuit comprises a programmable read only memory.

15. The delay circuit of claim 14, wherein the programmable read only memory comprises a EEPROM.

16. The delay circuit of claim 14 or 15, wherein the programmable memory circuit comprises a flash memory.

**Patentansprüche**

1. Verzögerungsschaltung (40) zum Verzögern eines Eingangssignals mit:

einer Konstantquelle (48,42,52,44) mit einem Eingang zum Empfangen eines Eingangssignals (EINGANG) und mit einem Konstantstromausgang zum Liefern eines von dem Eingangssignal abhängigen Konstantstromes;

einem Konstantstromdrain (46,54,50,44) mit einem Eingang zum Empfangen des Eingangssignals und mit einem Konstantdrainausgang zum Abziehen eines von dem Eingangssignal abhängigem Konstantstromes;

einem Kondensator (56) mit einer ersten Platte und einer zweiten Platte, wobei die erste Platte des Kondensators mit dem Konstantstromausgang des Konstantstromdrains verbunden ist, und die zweite Platte mit einer Spannungsreferenz verbunden ist; und einer Ausgangsstufe (58,60,62,64) mit einem Eingang, der mit der ersten Platte des Kondensators (56) verbunden ist, und mit einem Ausgang zum Liefern einer von der Spannung an dem Kondensator abhängigen Ausgabe,

dadurch gekennzeichnet, daß

der Eingang der Konstantstromquelle einen ersten Eingangsanschluß und der Eingang des Konstantstromdrains einen zweiten Eingangsanschluß aufweist, wobei der erste und der zweite Eingangsanschluß mit dem zu verzögernden Eingangssignal verbunden sind; und die erste Platte des Kondensators direkt mit dem Konstantstromausgang der Konstantstromquelle und dem Konstantdrainausgang des Konstantstromdrains verbunden ist.

2. Verzögerungsschaltung nach Anspruch 1, bei welcher die Konstantstromquelle einen ersten Stromspiegel aufweist.

3. Verzögerungsschaltung nach Anspruch 1, bei welcher der Konstantstromdrain einen zweiten Stromspiegel aufweist.

4. Verzögerungsschaltung nach Anspruch 2, bei welcher der erste Stromspiegel einen ersten Transistor (42) mit einem Steuerelement aufweist, welches mit einem leitenden Teil des ersten Transistors und einem Steuerelement eines zweiten Transistors (52) verbunden ist.

5. Verzögerungsschaltung nach Anspruch 4, bei welcher der erste und der zweite Transistor MOSFETs sind.

6. Verzögerungsschaltung nach Anspruch 5, bei welcher die MOSFETs p-Kanal-MOSFETs sind.

7. Verzögerungsschaltung nach Anspruch 3, bei welcher der zweite Stromspiegel einen dritten Transistor (46) mit einem Steuerelement aufweist, welches mit einem leitenden Teil des dritten Transistors und einem Steuerelement eines vierten Transistors (54) verbunden ist.

8. Verzögerungsschaltung nach Anspruch 7, bei welcher der dritte und der vierte Transistor MOSFETs sind.

9. Verzögerungsschaltung nach Anspruch 8, bei welcher die MOSFETs n-Kanal-MOSFETs sind.

10. Verzögerungsschaltung zum Verzögern eines Eingangssignals mit:

mehreren Stromspiegel-Stromquellen (48,42,82,86,90,94), wobei jede Stromspiegel-Stromquelle einen Freigabeeingang, ein Stromspiegelverhältnis, einen ersten Eingangsanschluß zum Empfangen des Eingangssignals und einen ersten Konstantstromausgang zum Liefern eines von dem Eingangssignal proportional abhängigen Konstantstroms in Abhängigkeit von dem Stromspiegelverhältnis aufweist;
mehreren Stromspiegel-Stromdrains (46,50,84,88,92,96), wobei jeder Stromspiegel-Stromdrain einen Freigabeeingang, ein Stromspiegelverhältnis, einen zweiten Eingangsanschluß zum Empfangen des Eingangssignals und einen Konstantdrainausgang zum Abziehen eines von dem Eingangssignal proportional abhängigen Konstantstroms in Abhängigkeit von dem Stromspiegelverhältnis aufweist;
einer Steuerschaltung (80) für eine programmierbare Verzögerung mit mehreren Freigabesignalen, wobei jedes Signal mit einer Stromspiegel-Stromquelle und einem Stromspiegel-Stromdrain derart verbunden ist, daß die Steuerschaltung für eine programmierbare Verzögerung selektiv ein Paar von Stromspiegel-Stromquelle und -drain freigibt;
einem Kondensator (56) mit einer ersten Platte und einer zweiten Platte, wobei die erste Platte des Kondensators direkt mit den Konstantstromausgängen der mehreren Stromspiegel-Stromquellen und den Konstantdrainausgängen der mehreren Stromdrains verbunden ist, und die zweite Platte mit einer Spannungsreferenz verbunden ist; und
einer Ausgangsstufe (98) mit einem Eingang, der mit der ersten Platte des Kondensators (56) verbunden ist, und mit einem Ausgang zum Liefern einer von der Spannung auf dem Kondensator abhängigen Ausgabe.

11. Verzögerungsschaltung nach Anspruch 10 mit:

einem ersten Eingangstransistor (48) mit einem Steuerelement, welches den ersten Eingangsanschluß zum Empfangen des Eingangssignals bildet, und mit einem Strompfad mit einem ersten Ende, das mit einer Spannungsquelle ($V_{DD}$) verbunden ist, und mit einem zweiten Ende;
einem zweiten Eingangstransistor (50) mit einem Steuerelement, welches den zweiten Eingangsanschluß zum Empfangen des Eingangssignals bildet, und mit einem Strompfad mit einem ersten Ende und einem zweiten Ende, das mit einer Spannungsreferenz verbunden ist;

einem ersten Bias-Transistor (42), welcher einen Strompfad mit einem mit der Spannungsquelle ($V_{DD}$) verbundenen ersten Ende und mit einem zweiten Ende und ein Steuerelement aufweist, wobei das zweite Ende mit dem Steuerelement und dem zweiten Ende des Strompfades des ersten Eingangstransistors (48) verbunden ist;

einem Widerstand (44) mit einem ersten Ende, das mit dem zweiten Ende des ersten Bias-Transistors verbunden ist, und mit einem zweiten Ende;

einem zweiten Bias-Transistor (46) mit einem Strompfad von dem zweiten Ende des Widerstandes zu der Spannungsreferenz, und mit einem Steuerelement, das mit dem zweiten Ende des Widerstandes und dem ersten Ende des Strompfades des zweiten Eingangstransistors (50) verbunden ist;

mehreren Konstantstromquellen (82;86;90; 94), wobei jede Konstantstromquelle der mehreren Konstantstromquellen einen Strompfad zwischen einem entsprechenden Freigabeausgang der Steuerschaltung (80) für eine programmierbare Verzögerung und der ersten Platte des Kondensators (56) aufweist, und mit einem Bias-Eingang, der mit dem Steuerelement des ersten Bias-Transistors derart verbunden ist, daß jede Stromspiegel-Stromquelle den ersten Eingangstransistor (48), den ersten Bias-Transistor (42), eine der Konstantstromquellen und den Widerstand (44) umfaßt;

mehreren Konstantstromdrains (84;88;92;96) , wobei jeder Konstantstromdrain der mehreren Konstantstromdrains einen Strompfad zwischen einem entsprechenden Freigabeausgang der Steuerschaltung (80) für eine programmierbare Verzögerung und der ersten Platte des Kondensators (56) und einen Bias-Eingang aufweist, der mit dem Steuerelement des zweiten Bias-Transistors derart verbunden ist, daß jeder Stromspiegel-Stromdrain den zweiten Eingangstransistor (50), den zweiten Bias-Transistor (46), einen der Konstantstromdrains und den Widerstand (44) umfaßt.

12. Verzögerungsschaltung nach Anspruch 10 oder 11, bei welcher die Schaltung (80) für eine programmierbare Verzögerung eine digitale Schaltung umfaßt.

13. Verzögerungsschaltung nach Anspruch 12, bei welcher die digitale Schaltung eine programmierbare Speicherschaltung umfaßt.

14. Verzögerungsschaltung nach Anspruch 13, bei welcher die programmierbare Speicherschaltung einen programmierbaren Nur-Lese-Speicher umfaßt.

15. Verzögerungsschaltung nach Anspruch 14, bei welcher der programmierbare Nur-Lese-Speicher einen EEPROM umfaßt.

16. Verzögerungsschaltung nach Anspruch 14 oder 15, bei welcher die programmierbare Speicherschaltung einen Flash-Speicher umfaßt.

**Revendications**

1. Circuit à retard (40) pour retarder un signal d'entrée, comprenant :

une source constante (48, 42, 52, 44) ayant une entrée pour recevoir un signal d'entrée (ENTREE) et ayant une sortie de courante constant pour délivrer un courant constant sensible au signal d'entrée ;

un drain de courant constant (46, 54, 50, 44) ayant une entrée pour recevoir le signal d'entrée et ayant une sortie de drain constante pour drainer un courant constant en réponse au signal d'entrée ;

un condensateur (56) ayant une première armature et une seconde armature, la première armature du condensateur étant connectée à la sortie de courant constante du drain de courant constant, la seconde armature étant connectée à une référence de tension ; et

un étage de sortie (58, 60, 62, 64) ayant une entrée connectée à la première armature du condensateur (56) et ayant une sortie pour délivrer une sortie sensible à la tension sur le condensateur, caractérisé en ce que

l'entrée de la source de courant constant comprend une première borne d'entrée et l'entrée du drain de courant constant comprend une seconde borne d'entrée, les première et seconde bornes d'entrée étant connectées au signal d'entrée devant être retardé ; et

la première armature du condensateur est connectée directement à la sortie de courant constant de la source de courant constant et à la sortie de drain constante du drain de courant constant.

2. Circuit à retard de la revendication 1, dans lequel la source de courant constant comprend un premier miroir de courant.

3. Circuit à retard de la revendication 1, dans lequel le drain de courant constant comprend un second miroir de courant.

4. Circuit à retard de la revendication 2, dans lequel le premier miroir de courant comprend un premier transistor (42) ayant un élément de commande connecté à un élément conducteur du premier transistor et à un élément de commande d'un deuxième transistor (52).

5. Circuit à retard de la revendication 4, dans lequel les premier et deuxième transistors sont des MOSFET.

6. Circuit à retard de la revendication 5, dans lequel les MOSFET sont des MOSFET à canal p.

7. Circuit à retard de la revendication 3, dans lequel le second miroir de courant comprend un troisième transistor (46) ayant un élément de commande connecté à un élément conducteur du troisième transistor et à un élément de commande d'un quatrième transistor (54).

8. Circuit à retard de la revendication 7, dans lequel les troisième et quatrième transistors sont des MOSFET.

9. Circuit à retard de la revendication 8, dans lequel les MOSFET sont des MOSFET à canal n.

10. Circuit à retard pour retarder un signal d'entrée comprenant :

une pluralité de sources de courant à miroir de courant (48, 42, 82, 86, 90, 94), chaque source de courant à miroir de courant ayant une entrée de validation, ayant un rapport de miroir de courant, ayant une première borne d'entrée pour recevoir le signal d'entrée et ayant une sortie de courant constant pour délivrer un courant constant proportionnellement sensible au signal d'entrée dépendant du rapport de miroir de courant ;

une pluralité de drains de courant à miroir de courant (46, 50, 84, 88, 92, 96), chaque drain de courant à miroir de courant ayant une entrée de validation, ayant un rapport de miroir de courant, ayant une seconde borne d'entrée pour recevoir le signal d'entrée et ayant une sortie de drain constante pour drainer un courant constant proportionnellement sensible au signal d'entrée dépendant du rapport de miroir de courant ;

un circuit de commande à retard programmable (80) ayant plusieurs signaux de validation, chaque signal étant connecté à une source de courant à miroir de courant et à un drain de courant à miroir de courant, de sorte que le circuit de commande à retard programmable valide de façon sélective une paire de source et de drain de courant à miroir de courant ;

un condensateur (56) ayant une première armature et une seconde armature, la première armature du condensateur étant directement connectée aux sorties de courant constant des plusieurs sources de courant à miroir de courant et aux sorties de drain constant de la pluralité de drains de courant, la seconde armature étant connectée à une référence de tension ; et

un étage de sortie (98) ayant une entrée connectée à la première armature du condensateur (56) et ayant une sortie pour délivrer une sortie sensible à la tension sur le condensateur.

11. Circuit à retard de la revendication 10, comprenant :

un premier transistor d'entrée (48) ayant un élément de commande procurant la première borne d'entrée pour recevoir le signal d'entrée, et ayant un trajet de courant avec une première extrémité connectée à une source de tension ($V_{DD}$) et une seconde extrémité ;

un second transistor d'entrée (50) ayant un élément de commande procurant la seconde borne d'entrée pour recevoir le signal d'entrée, et ayant un trajet de courant avec une première extrémité et une seconde extrémité connectées à une référence de tension ;

un premier transistor de polarisation (42) ayant un trajet de courant avec une première extrémité connectée à la source de tension ($V_{DD}$), ayant une seconde extrémité, et ayant un élément de commande, dans lequel la seconde extrémité est connectée à l'élément de commande et à la seconde extrémité du trajet de courant du premier transistor d'entrée (48) ;

une résistance (44) ayant une première extrémité connectée à la seconde extrémité dudit premier transistor de polarisation et ayant une seconde extrémité ;

un second transistor de polarisation (46) ayant un trajet de courant allant de la seconde extrémité de ladite résistance à la référence de tension, et ayant un élément de commande connecté à la seconde extrémité de ladite résistance et à la première extrémité du trajet de courant dudit second transistor d'entrée (50) ;

une pluralité de sources de courant constant (82 ; 86 ; 90 ; 94), chaque source de courant constant de la pluralité des sources de courant constant ayant un trajet de courant entre une sortie de validation correspondante dudit circuit de commande à retard programmable (80) et la première armature dudit condensateur (56), et ayant une entrée de polarisation connectée à l'élément de commande dudit premier transistor de polarisation, de sorte que chaque source de courant à miroir de courant comprend le premier transistor d'entrée (48), le premier transistor de polarisation (42), une desdites sources de courant constant et la résistance (44) ;

une pluralité de drains de courant constant (84 ; 88 ; 92 ; 96), chaque drain de courant constant de la pluralité des drains de courant constant ayant un trajet de courant entre une sortie de validation correspondante dudit circuit de commande à retard programmable (80) et la première armature dudit condensateur (56), et ayant une entrée de polarisation connectée à l'élément de commande dudit second transistor de polarisation, de sorte que chaque drain de courant à miroir de courant comprend le second transistor d'entrée (50), le second transistor de polarisation (46), un desdits drains de courant constant et la résistance (44).

12. Circuit à retard de la revendication 10 ou 11, dans lequel ledit circuit à retard programmable (80) comprend un circuit numérique.

13. Circuit à retard de la revendication 12, dans lequel le circuit numérique comprend un circuit à mémoire programmable.

14. Circuit à retard de la revendication 13, dans lequel le circuit de mémoire programmable comprend une mémoire morte programmable.

15. Circuit à retard de la revendication 14, dans lequel la mémoire morte programmable comprend une EEPROM.

16. Circuit à retard de la revendication 14 ou 15, dans lequel le circuit de mémoire programmable comprend une mémoire flash.

FIG. 1
(PRIOR ART)

FIG. 2
(PRIOR ART)

FIG. 3

12% OF
DIE AREA

72

P-CHANNEL
TRANSISTORS

70

RESISTOR

50% OF
DIE AREA

CAPACITOR

*FIG. 4*

25% OF
DIE AREA

76

N-CHANNEL
TRANSISTORS

74

12% OF
DIE AREA

*FIG. 5*

V_DD

PROGRAMMABLE DELAY CONTROL

80

48

100    102    104    106

82    86    90    94

42

98

INPUT ○

44

OUTPUT

46

84    88    92    96

56

50